Europäisches Patentamt

European Patent Office

Office européen des brevets

(19)

(11) EP 0 782 267 A2

(12) EUROPEAN PATENT APPLICATION

(43) Date of publication:
02.07.1997 Bulletin 1997/27

(51) Int. Cl.$^6$: H03K 17/687, H03K 17/693

(21) Application number: 96120941.8

(22) Date of filing: 27.12.1996

(84) Designated Contracting States:
DE NL SE

(30) Priority: 27.12.1995 JP 340453/95

(71) Applicant: NEC CORPORATION
Tokyo (JP)

(72) Inventor: Miya, Tatsuya
Minato-ku, Tokyo (JP)

(74) Representative: Glawe, Delfs, Moll & Partner
Patentanwälte
Postfach 26 01 62
80058 München (DE)

(54) Semiconductor switch

(57) In an FET switch performing the switching operation by utilizing the on-state and the off-state of the FETs, the potentials of the drain and the source of each FET constituting the switch are uniquely determined by a control voltage applied from the outside, the pinch-off voltage of the FET used, the internal capacity of the FET and the capacity of dc cutting capacitors, by constructing the switch in such a form that no dc current flows in the FETs by virtue of grounding the drain and the source of all the constituent FETs. The switching operation thus becomes possible without a bias circuit for applying a positive reference potential from the outside.

FIG. 2

EP 0 782 267 A2

## Description

### BACKGROUMD OF THE INVENTION

The present invention relates to a semiconductor switch circuit and, more particularly, to a semiconductor switch circuit used for various kinds of switching elements such as a transmission/reception changeover switch in a mobile communication equipment, a diversity changeover switch, a VCO changeover switch and so on.

In general, a semiconductor switch circuit is constructed to use a field effect transistor (FET). In the application field as described above, MESFETs are widely employed due to its good high frequency characteristics. That is, its threshold ($V_{th}$) voltage is negative. Accordingly, the FET is in an on-state on 0V bias. In order to cut off the FET, it is required to supply the gate there of with such a control voltage that is smaller than the threshold $V_{th}$. For this purpose, a negative voltage is used as the control voltage, as disclosed in, for example, Japanese Laid-Open (Kokai) Patent Publication Hei 6-152361. It is further disclosed in Paper No. 2-265, Spring Meeting of Electronic Information Society of Japan, 1994 to employ a positive voltage as a control voltage. The latter circuit is preferable due to using a positive voltage.

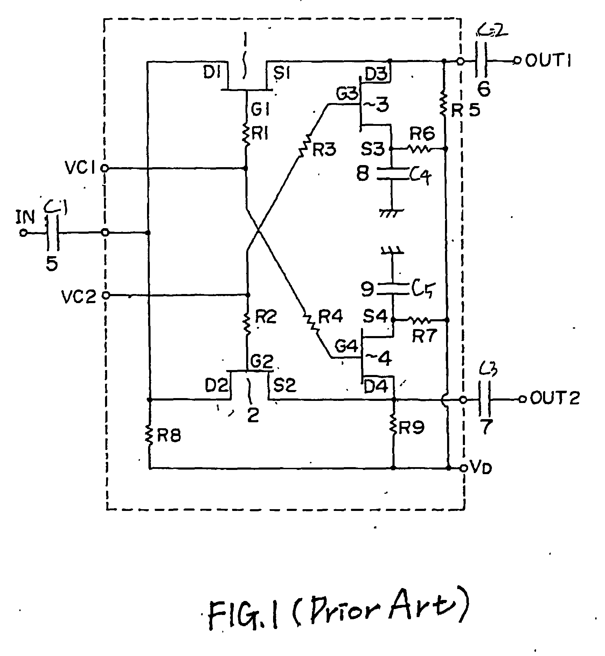

Referring now to Fig. 1, such a switch circuit that uses a positive control voltage in accordance with the prior art includes a voltage terminal $V_D$ supplied with a positive power voltage, four MESFETs 1 to 4, and a bias circuit including eight resistors R1 to R8 and five capacitors C1 to C5, which are connected as shown. The capacitors C1 to C5 are employed to cut dc components. Each of the FETs 1 to 4 has the same threshold voltage as one another.

In operation, assume that a potential equivalent to the power supply voltage $V_D$ is applied to a switch control terminal $v_{C1}$ and a potential lower than the absolute value $V_{th}$ of the threshold voltage of the FET is applied to a second switch control terminal $v_{C2}$. In this explanation, the potential at the terminal $v_{C2}$ is zero. However, it may be possible to supply such a voltage that is smaller in absolute value than the threshold voltage of the FET. In this state, the gate potentials of FET1 and FET4 are rendered conductive to present the low impedance state. On the other hand, the FET2 and FET3 are in the off-state to present the high impedance state. Thus, a high frequency signal supplied to an input terminal IN is transmitted to an output terminal OUT1 through the FET1 with low impedance.

When, on the other hand, 0V is applied to the $V_{C1}$ and a potential equivalent to $V_D$ is applied to the $V_{C2}$, the FET1 and the FET4 go to the off-state, and the FET2 and the FET3 go to the on-state, so that the signal at the input terminal IN is derived from an output terminal OUT2 through the FET2.

Thus, the switch circuit shown in Fig. 1 can operate on a positive voltage. However, this is done by providing a biasing circuit composed of the resistors R5 to R9 and the bias terminal $V_D$. For this reason, the switch circuit formed on a semiconductor chip occupies a large area.

### SUMMARY OF THE INVENTION

An object of this invention is to provide an improved switch circuit suitable for being a semiconductor device.

Another object of this invention is to simplify a circuit construction and reduce the chip area.

Still another object of this invention is to reduce the size of a package.

A switch circuit according to the present invention is featured by removing a biasing circuit by use of an internal self-biasing action of respective FETs. Specifically, the potentials of a drain and a source of each of FETs constituting the switch are automatically determined based on the stray or parasitic capacitance of each FET. A bias circuit is thus eliminated, so that an improvement in insertion loss, chip size reduction and reduction in the number of terminals are attained.

### BRIEF DESCRIPTION OF THE DRAWINGS

Figure 1 is an equivalent circuit diagram of a conventional FET switch.

Figure 2 is an equivalent circuit diagram of a first embodiment of this invention.

Figure 3 is an equivalent circuit diagram of a second embodiment of this invention.

### DESCRIPTION OF THE PREFERRED EMBODIMENTS

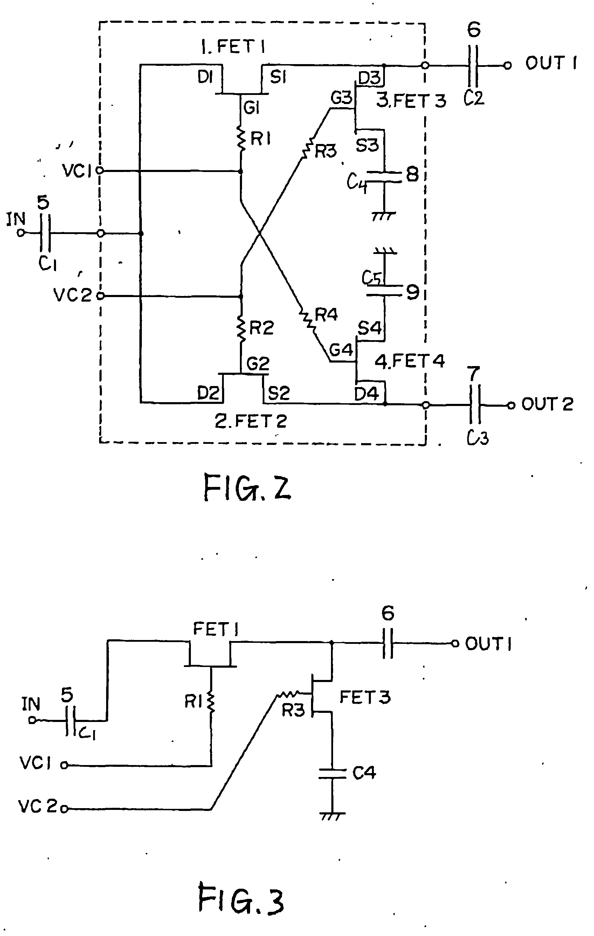

Referring now to Fig. 2, a first embodiment of this invention constitutes a single pole double throw (SPDT) switch formed of N-channel Schottky-barrier FETs 1, 2, 3 and 4, and has a configuration in which a bias circuit which supplies a reference potential by means of resistors $R_5$, $R_6$, $R_7$, $R_8$ and $R_9$ is eliminated from the configuration of the conventional SPDT switch shown in Fig. 1.

Namely, the drain electrode $D_1$ and the source electrode $S_1$ of FET1 are connected to an input terminal IN and an output terminal OUT1 through capacitors $C_1$ and $C_2$, respectively. The drain $D_2$ of FET2 is connected to the drain $D_1$ of the FET1, and the source $S_2$ of the FET2 is connected to an output terminal OUT2 through a capacitor $C_3$.

The drain $D_3$ of FET3 is connected to the source $S_1$ of the FET1, and the source $S_3$ of the FET3 is grounded through a capacitor $C_4$. The drain $D_4$ of FET4 is connected to the source $S_2$ of the FET2, and the source $S_4$ of the FET4 is grounded through a capacitor $C_5$.

The gate $G_1$ of the FET1 and the gate $G_4$ of the FET4 are connected to a bias (namely, switch control) terminal $V_{C1}$ through resistors $R_1$ and $R_4$, respectively, and the gate $G_2$ of the FET2 and the gate $G_3$ of the FET3 are connected to a bias terminal $v_{C2}$ through

resistors $R_2$ and $R_3$, respectively.

In this configuration of the switch, when $+V_D$ and 0V, for example, are applied to the bias terminals $C_{C1}$ and $V_{C2}$, respectively, the potentials of the $D_1$, $D_2$ and $D_3$, and the $S_1$, $S_2$ and $S_3$ are determined uniquely by a self-bias operation to render the FETs 1 and 4 conductive and FETs 2 and 3 nonconductive. Specifically, the $S_1$ is given a potential obtained by dividing the applied voltage $+V_D$ by the stay capacities of the FET1 and FET2, and the capacitor $C_4$. If the capacitance of more than several pF is chosen for the $C_4$, the capacity $C_{G1S1}$ between the $G_1$ and $S_1$ of the FET1 and the capacity $C_{D3S3}$ between the $D_3$ and $S_3$ of the FET3 satisfy the conditions $C_{G1S1} \ll C_4$ and $C_{D3S3} \ll C_4$, respectively, so that there hold the relation $S_1 \doteq V_D$. Since $S_1 = D_3$, it follows that $D_3 \doteq V_D$. Next, consider the $S_3$. Because of the conditions $D_3 = V_D$ and $G_3 = 0$ a depletion layer is formed between the $G_3$ and the $D_3$ of the FET3, and the spread of the depletion layer extends toward the side of the $S_3$ up to where there occurs pinch-off between the $G_3$ and $S_3$. Consequently, the potential of the $S_3$ goes to the pinch-off voltage $V_p$ of the FET. As a result, the FET1 goes to the on-state and the FET3 goes to the off-state.

As for the $D_2$, $S_2$ and $D_4$ the conditions $D_2 \doteq S_2 = D_4 \doteq V_D$ can be obtained by setting $C_{D2S2} \ll C_5$. Since the potential $G_4$ is equal to the potential of $V_D$, no formation of a depletion layer takes place between the $G_4$ and the $D_4$, and there is obtained the relation $S_4 \doteq D_4 \doteq V_D$. As a result, the FET2 goes to the off-state and the FET4 goes to the on-state.

As described in the above, the same operation as in the case with a bias circuit for applying a positive reference potential from the outside can be realized even without the use of such a circuit, and it is possible to let the FETs 1, 2, 3 and 4 function as a switch.

In this way, the elimination of the bias circuit for applying a positive reference potential leads to such effects as the improvement of the insertion loss, reduction of the chip size and reduction of the number of terminals, and at the same time it is possible to realize an improvement in the switching performance and the reduction in the package size of a switching circuit controlled exclusively by a positive potential.

Next, referring to Fig. 3, a second embodiment of this invention will be described.

In Fig. 3 which shows an equivalent circuit diagram of the second embodiment of this invention, the difference from the first embodiment resides in the fact that the FET2 and FET4, and the components $R_2$, $R_4$, $C_5$ and $C_3$ connected to the FET2 and FET4 are eliminated. Here, a single pole single throw (SPST) switch is formed using the FET1 and FET3, but in this case it is also possible to obtain a switching circuit which can control the FET1 and FET3 by a positive voltage even when the bias circuit for applying a positive reference potential is eliminated, as described in conjunction with the first embodiment.

A first effect of this invention is that the insertion loss can be improved by 0.1 - 0.2 dB, which enhances the switching performance. This reduction in the insertion loss is brought about by the elimination of the bias circuit for applying a positive reference potential.

A second effect of this invention is that the chip size can be reduce by about 10%. This is due to the simplification of the circuitry brought about by the elimination of the bias circuit for applying a positive reference potential.

A third effect of this invention is the reduction in the package size. This is due to the reduction, by one, in the number of required terminals resulting from the elimination of the bias circuit for applying a positive reference potential.

It is apparent that the present invention is not limited to the above embodiments, but may be modified and changed without departing from the scope and spirit of the invention.

## Claims

1. A semiconductor switch circuit comprising an input terminal supplied with an input signal, a first output terminal, first and second control terminals, a first transistor having first and second electrodes and a gate electrode coupled to said first control terminal, a first capacitor coupled between said input terminal and said first electrode of said first transistor, a second capacitor coupled between said second electrode of said first transistor and said first output terminal, a second transistor having a third electrode coupled to said second electrode of said first transistor, a fourth electrode and a gate electrode coupled to said second control terminal, and a third capacitor coupled between said fourth electrode of said second transistor and a reference potential line, said first transistor being rendered conductive when said first control terminal takes a first voltage level, said second transistor being self-biased so as to be rendered nonconductive by stray capacitances of said first, and second transistors, said first voltage level and a second voltage level supplied to said second control terminal, said first voltage level being higher than said second voltage level, and said second voltage level being equal to or higher than a reference voltage level of said reference voltage line.

2. The circuit as claimed in claim 1, wherein each of said first and second transistors is of an N-channel Schottky-barrier transistor, each of said reference voltage level and said second voltage level is a ground level, and said first voltage level is a positive voltage.

3. The circuit as claimed in claim 1, further comprising a second output terminal, a third transistor having a fifth electrode coupled to said first electrode of said first transistor, a sixth electrode and a gate electrode coupled to said second control terminal, a fourth capacitor coupled between said sixth electrode of said third transistor and said second output terminal, a fourth transistor having a seventh electrode coupled to said sixth electrode of said third transistor, an eighth electrode and a gate electrode coupled to said first control terminal, and a fifth capacitor coupled between said eighth electrode of said fourth transistor and said reference voltage line.

FIG.1 (Prior Art)

FIG. 2

FIG. 3